# EUROPEAN PATENT APPLICATION

(11) **EP 4 468 364 A1**
(43) Date of publication of application: **27.11.2024**
(21) Application number: 24175396.1
(22) Date of filing: 13.05.2024
(51) Int. Cl.: H01L 29/06, H01L 29/08, H01L 29/78

(54) **POWER ELECTRONIC DEVICE WITH IMPROVED ELECTRICAL PERFORMANCES**

(30) Priority: 26.05.2023 IT 202300010677
(71) Applicant: STMicroelectronics International N.V., 1228 Plan-les-Ouates, Geneva (CH)
(72) Inventor: CASCINO, Salvatore, 95030 GRAVINA DI CATANIA (CT) (IT); SAGGIO, Mario Giuseppe, 95020 ACI BONACCORSI (CT) (IT); PULVIRENTI, Mario, 95025 ACI S. ANTONIO (CT) (IT)
(74) Representative: Studio Torta S.p.A.

(57) **Abstract**

Electronic device (10) comprising a semiconductor body (15) of SiC having an upper surface (15a) and a lower surface (15b) opposite to each other along a first axis (Z) and comprising: a drain substrate (16) extending into the semiconductor body (15) starting from the bottom surface (15b) and with a first electrical conductivity type; a drift layer (17) extending into the semiconductor body (15) starting from the upper surface (15a) and with the first electrical conductivity type and a second dopant concentration; a body region (19) accommodated in the drift layer (17); and a source region (20) accommodated in the body region (19). The electronic device (10) further comprises a gate structure (21) on the upper surface (15a). The gate structure (21), the source region (20), the body region (19), the drift layer (17) and the drain substrate (16) form a first MOSFET portion (10'ₐ) of a first MOSFET (10'). The semiconductor body (15) further comprises at least one doped pocket region (25) which is buried in the drift layer (17), has a second electrical conductivity type and is aligned along the first axis (Z) with the source region (20) and/or with the gate structure (21).

## Description

### TECHNICAL FIELD

The present invention relates to a power electronic device with improved electrical performances. In particular, it relates to a silicon carbide electronic device comprising one or more power MOSFETs with improved electrical operation and reliability. Furthermore, it relates to an apparatus comprising the power electronic device.

### STATE OF THE ART

As known, power devices are electronic devices for working at high voltages and/or currents, for example with voltages that reach 1700V in an inhibition state, and up to several tens/hundreds of Amperes in current and are used in multiple application fields. For example, they are commonly used in audio amplifiers, motor control devices, power supplies or power switches, and include power diodes, power transistors, thyristors, Insulated Gate Bipolar Transistors (IGBTs), Metal-Oxide-Semiconductor Field-effect Transistors (MOSFETs).

In power devices, semiconductor materials are generally used which have a wide bandgap (e.g., having an energy value Eg of the bandgap greater than 1.1 eV), low on-state resistance (R_{ON}), a high value of thermal conductivity, high operating frequency and high saturation velocity of charge carriers. A material having these characteristics and designed to be used for manufacturing electronic components is silicon carbide (SiC). In particular, silicon carbide, in its different polytypes (e.g., 3C-SiC, 4H-SiC, 6H-SiC), is preferable to silicon as to the properties listed above.

Electronic devices formed starting from a silicon carbide substrate, compared to similar devices provided on a silicon substrate, have numerous advantages, such as low output resistance in conduction, low leakage current, high operating temperature and high operating frequencies.

In particular, SiC MOSFETs have demonstrated higher switching performances, which make these SiC power devices particularly favorable for high-frequency applications.

In particular, power MOSFETs are sometimes used in saturation mode (operation in active region) as sources of constant current, tuned by varying the value of the gate-source voltage V_{GS}. Indeed, in saturation mode, the drain-source current I_{DS} is almost independent of the drain-source voltage V_{DS}, but varies as a function of the gate-source voltage V_{GS}.

In different applications, power MOSFETs operate in a linear mode (also said ohmic or triode region) of switching, switching from an ON-state to an OFF-state and vice versa. The linear mode is characterized by a linear relationship between the current I_{DS} and the voltage V_{DS}, and therefore by a constant value of drain-source on-resistance R_{DSon} (hereinafter, also referred to as on-resistance R_{DSon}). In this operating mode, the switching speed between OFF- and ON-states affects the characteristics of the power MOSFET device. In fact, the slower the transition from the ON-state to the OFF-state, the greater the power dissipation during switching and the greater the probability of a thermal drift of the threshold voltage V_{TH} of the power MOSFET.

SiC power MOSFETs are therefore designed to minimize switching time, thus reducing the probability that these disadvantages will occur. However, reducing the switching time causes, in the dynamic and transient regime, known "ringing" phenomena of the MOSFET currents and voltages during the switching phase (i.e., of the substantially sinusoidal oscillations in the currents and voltages, which begin upon switching and decrease in amplitude over time up to ending after a transient period starting from the switching moment). The ringing phenomenon causes current and voltage "overshoots" (i.e., current and voltage oscillation peaks with significant amplitude) that are often greater than what the MOSFET is designed to safely withstand. Therefore, overshoots may damage the MOSFET, increase power losses and introduce noises and electromagnetic interferences of non-negligible importance.

Furthermore, the common trend in SiC power MOSFETs is to continuously downsize them in such a way as to allow a higher density of MOSFETs in the same unit of area and therefore increase the computational performances of devices with MOSFETs without having to increase their size correspondently. In particular, in vertical-structure MOSFETs this is done by decreasing the distance between the body regions of each MOSFET cell underlying the gate structure. This downsizes the MOSFET but also causes a decrease in the gate-drain capacitance since the contact surface between the drift layer and the gate structure of the MOSFET decreases. The decrease in the gate-drain capacitance makes the drain region less capacitively coupled dynamically to the gate structure and therefore makes the drain region more subject to sudden variations of the drain voltage. This negative consequence is therefore responsible for the overshoots of the MOSFET and, more generally, for the ringing phenomenon.

The decrease in the gate-drain capacitance reduces the "parasitic turn-on" (PTO) phenomenon of the MOSFET, i.e. the turn-on of the conduction channel of the MOSFET when the latter is controlled to operate in reverse mode but oscillations of the drain voltage are present which, due to the dynamic capacitive coupling between the gate structure and the drain region, generate corresponding oscillations of the gate voltage such as to activate the conduction of the MOSFET in any case. While generally undesired as it makes the MOSFET less reliable and more subject to malfunctions, PTO also has the positive effect of reducing the ringing phenomenon as it reduces the maximum amplitude of the MOSFET overshoots. However, since downsizing the MOSFET decreases the PTO, this phenomenon cannot be effectively used in scaled-down MOSFETs to reduce the ringing phenomenon.

Some solutions to the MOSFET ringing issue are known.

For example, it is known to increase the gate resistance by adding further series resistances to the gate structure, such as resistances integrated in the MOSFET or resistances external to the MOSFET. It has been verified that this reduces the ringing risk of the MOSFET. However, it is generally very difficult to suitably choose the resistance to be added to the gate structure without excessively degrading the electrical properties of the MOSFET. In fact, the increase in the gate resistance usually generates a significant increase in the switching time of the MOSFET and therefore a worsening of its operation when used in linear mode.

Furthermore, it is known to use external electronic circuits (e.g., "snubber" or "dumping" circuits based on RC circuits) to improve the electrical control of the gate structure and therefore to reduce the overshooting of the MOSFET. However, the presence of these electronic circuits external to the MOSFET complicates the design of the devices comprising MOSFETs and increases their cost and power consumption.

Furthermore, especially in high-power MOSFETs (i.e., in MOSFETs configured to work at drain-source voltages greater than about 1200 V), another commonly occurring issue is that of the "snappy" behavior of the MOSFET.

In particular, this behavior is identified by a sudden change of slope in the drain-source voltage and drain-source current curves which occurs, for example, when the high-power MOSFET is operated at a working voltage of about 1200 V, at a drain-source voltage equal to about 850 V, at a temperature of 175°C/200°C and with a value of rate of change of the recovery current di/dt greater than about 2.5 A/ns. This causes the occurrence of an overshoot of the drain-source voltage which may lead to instability and malfunction of the MOSFET, degradation of the electrical performances of the MOSFET and ringing phenomenon with resulting noise and electromagnetic interference disturbances. In extreme cases, the amplitude of this overshoot may reach or even exceed the avalanche breakdown voltage, causing breakdown by avalanche of the MOSFET.

It has been verified that the snappy behavior occurs due to the sudden recombination of minority charge carriers at the interface between the drift layer and the drain layer.

In fact, to ensure correct electrical operation, high-power MOSFETs have a low dopant concentration in the drift layer (e.g., lower than about 1·10¹⁶ at/cm³) and therefore a high number of minority carriers in the depletion region of the drift layer. If the MOSFET operates at high temperatures (e.g., greater than about 170°C), the lifetime of these minority carriers, which as known is proportional to the temperature of the MOSFET, may increase to such an extent as to make the complete recombination impossible before reaching the drain region. In this case, a part of the minority carriers does not recombine in the drift layer as it should instead occur, and only disappears at the interface between the drift layer and the drain layer. For a certain time interval starting from the moment in which the minority carriers start to recombine at the interface between the drift layer and the drain layer, this recombination generates an output parasitic capacitance Cₒₛₛ of the MOSFET (equal to the sum of the drain-source capacitance and of the gate-source capacitance) which is constant and therefore causes, during this time interval, the snappy behavior of the MOSFET.

This issue is instead secondary in low-power MOSFETs (i.e., in MOSFETs configured to work at drain-source voltages lower than about 1200 V and for example equal to about 650 V, which have higher dopant concentrations in the drift layer and therefore a higher recombination rate of minority carriers which decreases their average lifetime), as well as in MOSFETs that do not operate at high temperatures (e.g., which operate at temperatures lower than about 170°C and for example equal to about 30-100°C, and which therefore have a shorter average lifetime than the minority carriers).

Known solutions to this issue are similar to those previously presented to counteract the ringing of MOSFETs, and therefore comprise increasing the resistance of the gate structure or using external electronic circuits coupled to the MOSFET. The same disadvantages previously described therefore apply to these solutions.

Document Luo Hou-Cail et al., "Investigation of SiC VDMOSFET With Floating Island Structure Based on TCAD", IEEE Transactions on Electronic Devices, 1 May 2019 relates to a systematical investigation of SiC MOSFETs with p-type floating islands.

Document Ren Min et al., "A novel planar vertical double-diffused metal-oxide-semiconductor field-effect transistor with inhomogeneous floating islands", Chinese Physics B, 16 December 2011 relates to a planar vertical double-diffused metal-oxide-semiconductor field-effect transistor structure with inhomogeneous floating p-islands in the n-drift region.

Document US 2014/367771 A1 relates to semiconductor devices for high-voltage power electronic applications and methods of making the devices.

The aim of the present invention is to provide a power electronic device and a corresponding apparatus which overcome the drawbacks of the prior art.

### SUMMARY OF THE INVENTION

According to the present invention, a power electronic device and a corresponding apparatus are provided, as defined in the annexed claims.

### BRIEF DESCRIPTION OF THE DRAWINGS

For a better understanding of the present invention, a preferred embodiment is now described, purely by way of non-limiting example, with reference to the attached drawings, wherein:
- Figures 1-5 are cross-sectional views of respective embodiments of an electronic device;
- Figures 6A-6F show, in cross-sectional view, the change of a depletion region of a part of a MOSFET of the electronic device of Figures 1-5 as electrical control conditions of the MOSFET vary;
- Figures 7A and 7B are plots showing respective electrical signals of the electronic device of Figures 1-5;
- Figures 8 and 9 are cross-sectional views of respective and further embodiments of the electronic device;
- Figures 10A and 10B are top views with hidden parts of respective embodiments of the electronic device; and
- Figure 11 is a cross-sectional view of a further embodiment of the electronic device.

In particular, the Figures are shown with reference to a triaxial Cartesian system defined by an axis X, an axis Y and an axis Z, orthogonal to each other.

In the following description, elements common to the different embodiments have been indicated with the same reference numerals.

### DETAILED DESCRIPTION OF THE INVENTION

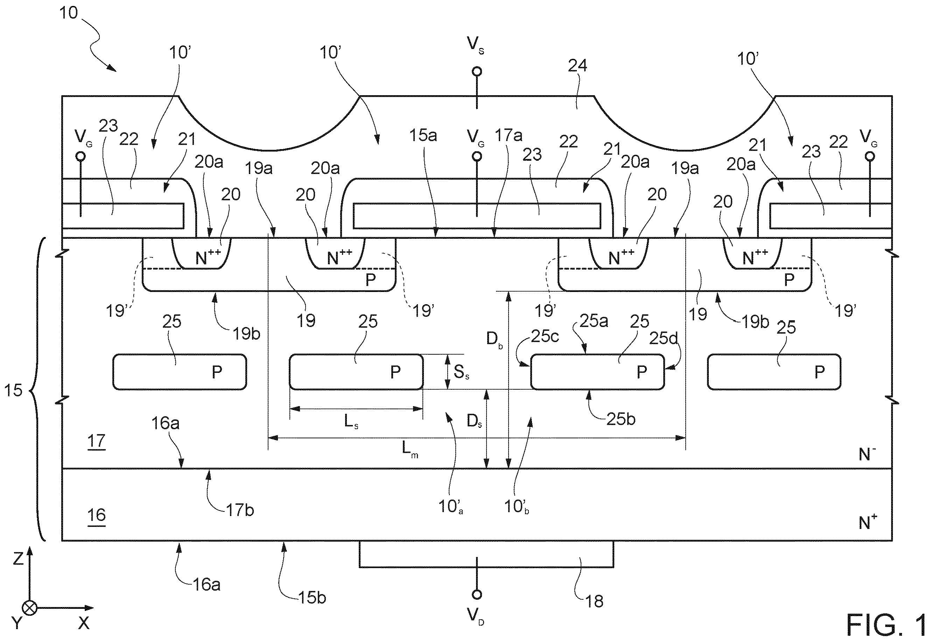

Figure 1 shows, in lateral-sectional view, an embodiment of a power electronic device 10.

In particular, the power electronic device 10 (hereinafter also referred to as electronic device 10 or more simply device 10) is shown in Figure 1 in a plane XZ defined by the axes X and Z. The device 10 has a main extension parallel to the axis Y and Figure 1 shows a cross-section perpendicular to this main extension.

The device 10 is for example comprised in an apparatus (not shown and of electrical/electronic type, such as notebook, mobile phone, server, TV, car, car recharging station or conversion system for photovoltaic panels).

The device 10 has an active area (not shown) wherein one or more MOSFETs 10', in particular vertical-structure MOSFETs (e.g., of enhancement type), are accommodated. In the exemplary and non-limiting embodiment of Figure 1, three MOSFETs 10' are shown arranged laterally to each other along the axis X to form a MOSFET array; however, the number of MOSFETs 10' may vary in a per se obvious manner and be, for example, higher (e.g., ten or one hundred) or lower (e.g., only one MOSFET).

The device 10 includes a substrate (or drain substrate) 16 of silicon carbide, SiC (such as 4H-SiC). The substrate 16 forms a drain region of the MOSFETs 10'.

The substrate 16 has a first electrical conductivity type (hereinafter an N-type conductivity is considered) and a first dopant concentration (or first conductivity value), for example in the order of magnitude of 10¹⁸ at/cm³.

The substrate 16 has an upper surface 16a and a lower surface 16b opposite to each other along the axis Z. For example, the substrate 16 has a thickness along the axis Z between the surfaces 16a and 16b comprised between about 50 um and about 350 µm, more particularly between about 160 um and about 200 µm, for example equal to about 180 um.

The device 10 includes a drift layer 17 of SiC (such as 4H-SiC) which extends over the substrate 16. In particular, the drift layer 17 is grown in an epitaxial manner on the substrate 16.

The drift layer 17 has the first electrical conductivity type (here of N-type) and a second dopant concentration lower than the first dopant concentration (e.g., lower than about 2.5·10¹⁶ at/cm³).

The drift layer 17 has an upper surface 17a and a lower surface 17b opposite to each other along the axis Z, wherein the lower surface 17b of the drift layer 17 is in contact with the upper surface 16a of the substrate 16.

For example, the drift layer 17 has a thickness along the axis Z between the surfaces 17a and 17b comprised between about 4 um and about 15 µm, for example equal to about 6.5 um.

The device 10 also includes a drain ohmic contact region, or layer, (not shown and for example of nickel silicide), which extends at the bottom surface 16b of the substrate 16 and forms an ohmic contact. For example, and in a manner known per se, the drain ohmic contact region may extend over the lower surface 16b of the substrate 16, or it may extend into the substrate 16 so as to be exposed by the latter at the lower surface 16b.

The device 10 also includes a drain metallization 18 which extends over the drain ohmic contact region so as to be in direct electrical contact with the substrate 16 and thus form a drain electrical terminal. The drain metallization 18 is of conductive material and for example is formed by a stack of metal layers, such as Ti/NiV/Ag or Ti/NiV/Au.

The device 10 also includes a plurality of body regions 19 which are accommodated in the drift layer 17 and extend starting from the upper surface 17a of the latter and towards the substrate 16 (without reaching the latter).

In detail, each body region 19 has a respective upper surface 19a which is exposed by the drift layer 17 and is substantially aligned with the upper surface 17a of the latter along the axis Z (i.e., they are lateral to one another).

The body regions 19 are spaced from each other along the axis X through the drift layer 17 and are arranged laterally to each other along the axis X. The body regions 19 have each main extension parallel to the axis Y.

The body regions 19 have a second electrical conductivity type opposite to the first electrical conductivity type (here, they are of P-type). The body regions 19 have a third dopant concentration (e.g., comprised between about 3·10¹⁷ at/cm³ and about 3·10¹⁸ at/cm³).

In particular, two body regions 19 are preset for each MOSFET 10' and each body region 19 is shared between two MOSFETs 10' consecutive to each other in the MOSFET array, as better detailed below.

The device 10 also includes, for each body region 19, two respective source regions 20 which are accommodated in the body region 19 and extend starting from the upper surface 19a of the latter and towards the drift layer 17 (without reaching the latter).

In detail, each source region 20 has a respective upper surface 20a which is exposed by the body region 19 and is substantially aligned with the upper surface 19a of the latter along the axis Z (i.e., they are lateral to one another).

The source regions 20 are spaced from each other along the axis X through the body region 19. The source regions 20 each have a main extension parallel to the axis Y.

The source regions 20 have the first electrical conductivity type (here, of N-type) and have a fourth dopant concentration greater than the first dopant concentration (e.g., comprised between about 1·10¹⁹ at/cm³ and about 1·10²¹ at/cm³ and for example equal to about 1·10²⁰ at/cm³).

In particular, two source regions 20 are present for each body region 19 and each of these two source regions 20 belongs to a respective MOSFET 10' of the two MOSFETs 10' which share the body region 19 considered.

The portions of each body region 19 which are interposed along the axis X between the source regions 20 and the drift layer 17 define respective channel regions 19' of the MOSFETs 10', through which electrical conduction occurs when the MOSFETs 10' are suitably biased.

Together, the substrate 16, the drift layer 17, the body regions 19 and the source regions 20 form a semiconductor body 15 of SiC of the device 10, which has an upper surface 15a (defined by the upper surfaces 17a, 19a and 20a of the drift layer 17, the body regions 19 and the source regions 20) and a lower surface 15b (defined by the lower surface 16b of the substrate 16) opposite to each other along the axis Z.

The device 10 also includes a respective gate structure 21 for each MOSFET 10'.

Each gate structure 21 extends over two respective channel regions 19' which face each other through the drift layer 17 and are part of two body structures 19 consecutive to each other along the axis X. In other words, each gate structure 21 extends over the channel regions 19' of the respective MOSFET 10'. The gate structure 21 also has a main extension parallel to the axis Y.

In particular, each gate structure 21 extends over the respective channel regions 19', over the portion of the drift layer 17 interposed between these channel regions 19' along the axis X and, possibly, over part of the respective source regions 20.

Each gate structure 21 comprises a gate insulating layer 22 on the upper surface 15a of the semiconductor body 15 and a gate region 23 surrounded in the plane XZ by the gate insulating layer 22.

The gate insulating layer 22 is of an insulating material such as silicon dioxide (SiO₂) and the gate region 23 is of a conductive material such as metal or doped polysilicon. In this manner the gate region 23 is physically and electrically insulated by the gate insulating layer 22 from the semiconductor body 15 (in detail, from the channel regions 19' whereon it is superimposed).

The gate regions 23 are also electrically connected to a gate metallization (not shown) of the device 10, in a manner per se known to the person skilled in the art. The gate metallization defines a gate terminal of the device 10.

As shown in Figure 1, each MOSFET 10' with vertical structure comprises a first and a second MOSFET portion 10'ₐ and 10'_{b}. The first MOSFET portion 10'ₐ is defined by the gate structure 21, the source region 20 to the left of the drift layer 17, by the respective body region 19 to the left of the drift layer 17 (in particular, by the channel region 19' to the left of the drift layer 17), by the drift layer 17 and the substrate 16, while the second MOSFET portion 10'_{b} is defined by the gate structure 21, the source region 20 to the right of the drift layer 17, by the respective body region 19 to the right of the drift layer 17 (in particular, by the channel region 19' to the right of the drift layer 17), by the drift layer 17 and the substrate 16.

Furthermore, the device 10 includes a respective source ohmic contact region, or layer (not shown and for example of nickel silicide) for each source region 20. The source ohmic contact regions extend at the upper surfaces 20a of the respective source regions 20 and form respective ohmic contacts. For example, and in a manner known per se, each source ohmic contact region may extend over the upper surface 20a of the source region 20, or it may extend into the source region 20 so as to be exposed by the latter at the upper surface 20a.

The device 10 also includes a source metallization 24 which extends over the source ohmic contact regions in such a way as to be in direct electrical contact with the source regions 20 and therefore form a source electrical terminal. In practice, the source metallization 24 extends over the gate structures 21 and onto the regions of the upper surface 15a of the semiconductor body 15 which are not covered by the gate structures 21, so as to be in direct electrical contact with the source regions 20. The source metallization 24 is of conductive material and for example is formed by a stack of metal layers, such as Ti/AlSiCu or Ni/AlSiCu.

The device 10 may also include a passivation layer (not shown) which extends over the source metallization 24, to protect the latter.

For example, and in a manner not shown and per se known, the active area of the device 10 is delimited externally, in a plane XY defined by the axes X and Y and substantially parallel to the upper surface 15a of the semiconductor body 15, by an edge termination region, or protection ring, which completely surrounds the MOSFETs 10' in the plane XY. For example, the edge termination region is a P-type implanted region. Optionally, the device 10 may also include an edge insulating layer (not shown) which extends over the upper surface 15a of the semiconductor body 15 in such a way as to be superimposed on the edge termination region along the axis Z, completely surround the MOSFETs 10' and laterally delimit the source metallization 24.

Furthermore, the device 10 comprises one or more doped pocket regions 25.

In the exemplary and non-limiting embodiment of Figure 1, two doped pocket regions 25 are present for each MOSFET 10', in particular a respective doped pocket region 25 for each MOSFET portion 10'ₐ and 10'_{b}. Nonetheless, and as better discussed below, the number of doped pocket regions 25 may vary and be, for example, higher or lower than what has been previously described (e.g., only one doped pocket region 25 for each MOSFET 10').

In the exemplary and non-limiting embodiment of Figure 1, the doped pocket regions 25 have a cross-section in the plane XZ which is substantially rectangular (e.g., rectangular with rounded corners). However, other closed polygonal shapes of the cross-sections in the plane XZ of the doped pocket regions 25 may similarly be considered, such as trapezoidal shapes, T shapes, mushroom-like shapes, etc.

The doped pocket regions 25 are buried in the drift layer 17 and are aligned along the axis Z (i.e., underlie) at least partially with the source regions 20 and/or with the gate structures 21 of the respective MOSFETs 10'. In particular, the doped pocket regions 25 extend at a distance from the body regions 19 and the upper surface 15a of the semiconductor body 15.

In detail, the doped pocket regions 25 are spaced from each other along the axis X through the drift layer 17.

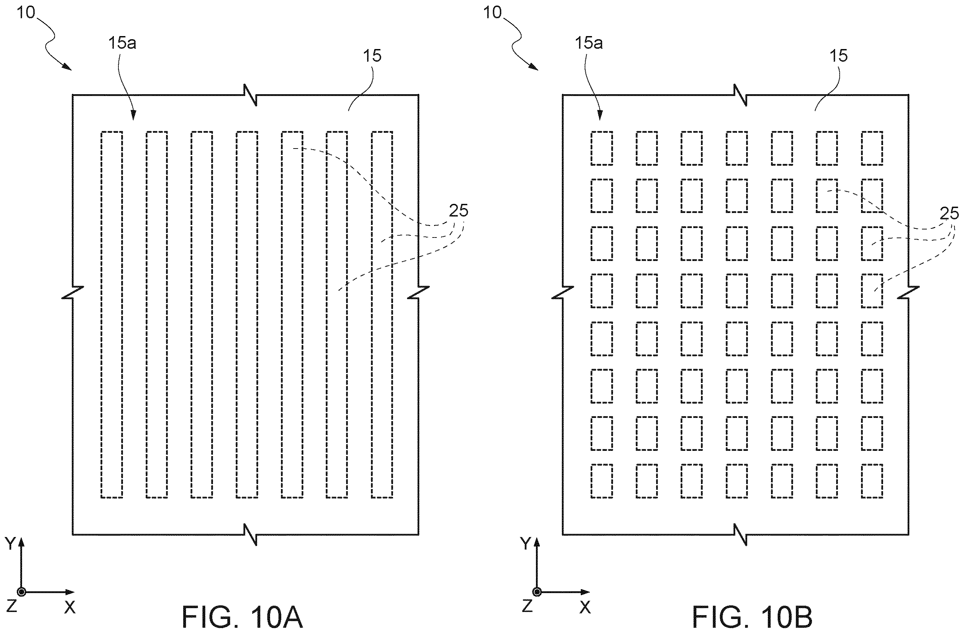

The doped pocket regions 25 may have a main extension parallel to the axis Y. For example, the doped pocket regions 25 may have the shape of a strip parallel to the axis Y, as better shown in Figure 10A. For example, the doped pocket regions 25 have a length, measured parallel to the axis Y, which is approximately equal to the length of the body regions 19, measured parallel to the axis Y.

The doped pocket regions 25 have the second electrical conductivity type (here of P-type) and have a doped pocket dopant concentration which is higher than the second dopant concentration of the drift layer 17. For example, the doped pocket regions 25 are doped with boron or aluminum.

In particular, the doped pocket dopant concentration is comprised between about 1·10¹⁷ at/cm³ and about 5·10¹⁷ at/cm³ (i.e. between about 10 and about 50 times the second dopant concentration of the drift layer 17) and for example is equal to about 3·10¹⁷ at/cm³, so that the doped pocket regions 25 are depleted at the breakdown voltage of the MOSFETs 10'.

According to one embodiment, the doped pocket regions 25 are arranged laterally to each other along the axis X, substantially at the same level along the axis Z. In other words, the doped pocket regions 25 are arranged in succession with each other along the axis X, at a same height with respect to the substrate 16.

Considering that the body regions 19 each have a minimum distance (or minimum body distance) D_{b} from the substrate 16 and that the doped pocket regions 25 each have a minimum distance (or minimum doped pocket distance) Dₛ from the substrate 16, the minimum distance Dₛ is lower than the minimum distance D_{b}.

In particular and as better described below, a ratio (or first ratio) D_{s/}D_{b} between the minimum distance Dₛ and the minimum distance D_{b} is comprised (boundary values included) between 0% and about 70%.

Considering that each MOSFET 10' has an average width (or average MOSFET width) Lₘ along the axis X and that each doped pocket region 25 has a maximum width (or maximum doped pocket width) Lₛ along the axis X, the maximum width Lₛ is lower than the average width Lₘ and, in particular, a ratio (or second ratio) Lₛ/Lₘ between the maximum width Lₛ and the average width Lₘ is comprised (boundary values included) between about 15% and about 300. For example, the average width Lₘ of each MOSFET 10' is measured between respective median axes, parallel to the axis Z, of the two body regions 19 of the MOSFET 10' considered; in other words it is measured parallel to the axis X between a center of the body region 19 to a center of the consecutive body region 19, i.e. between two points of the upper surfaces 19a of the respective body regions 19 which are each equidistant from the two source regions 20 present in the respective body region 19.

Furthermore, considering that the doped pocket regions 25 each have a maximum thickness (or maximum doped pocket thickness) Sₛ along the axis Z, a ratio (or third ratio) Sₛ/D_{b} between the maximum thickness Sₛ and the minimum distance D_{b} may be comprised (boundary values included) between about 10% and about 30%.

In greater detail, each body region 19 has a lower surface 19b opposite along the axis Z to the upper surface 19a. Furthermore, each doped pocket region 25 has an upper surface 25a and a lower surface 25b opposite to each other along the axis Z and has a first lateral surface 25c and a second lateral surface 25d opposite to each other along the axis X and joined and transverse to the surfaces 25a and 25b. The minimum distance D_{b} is defined along the axis Z between the lower surface 19b of each body region 19 and the upper surface 16a of the substrate 16. The minimum distance Dₛ is defined along the axis Z between the lower surface 25b of each doped pocket region 25 and the upper surface 16a of the substrate 16. The maximum width Lₛ is defined along the axis X between the first lateral surface 25c and the second lateral surface 25d of each doped pocket region 25. The maximum thickness Sₛ is defined along the axis Z between the upper surface 25a and the lower surface 25b of each doped pocket region 25.

According to an exemplary and non-limiting embodiment, the minimum distance D_{b} is comprised between about 5.2 µm and about 5.7 µm, the minimum distance Dₛ is comprised between about 0 µm and about 0.5 µm, the average width Lₘ is comprised between about 4.5 µm and about 5 µm, the maximum width Lₛ is comprised between about 0.9 µm and about 1.5 µm and the maximum thickness Sₛ is comprised between about 0.5 µm and about 1.2 µm.

According to an embodiment of the device 10 (for example shown in Figure 1 and wherein two doped pocket regions 25 are preset for each MOSFET 10'), each source region 20 is at least partially aligned vertically (i.e. parallel to the axis Z; in other words, superimposed or overlapping) with a respective one of the doped pocket regions 25. In turn, the doped pocket regions 25 may also be vertically aligned (i.e., underlie) with the gate structures 21 of the respective MOSFETs 10', or they may be vertically staggered with respect thereto (i.e., be vertically misaligned, thus not underlie, with respect thereto).

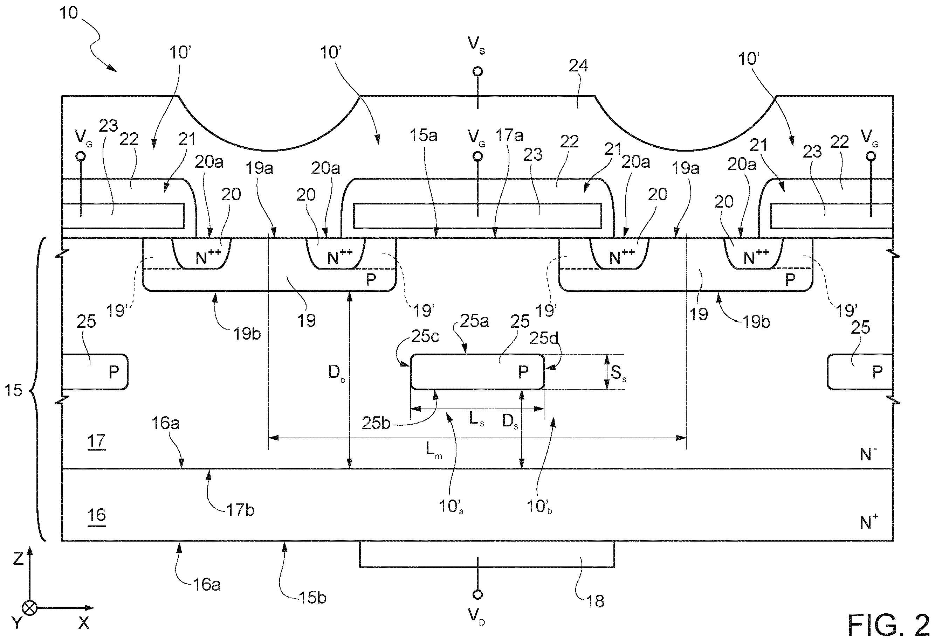

According to a different embodiment of the device 10 (for example shown in Figure 2 and wherein only one doped pocket region 25 is present for each MOSFET 10'), each gate structure 21 is at least partially vertically aligned (i.e., at least partially overlaps) with a respective one of the doped pocket regions 25 which in turn may be vertically staggered with respect to the source regions 20.

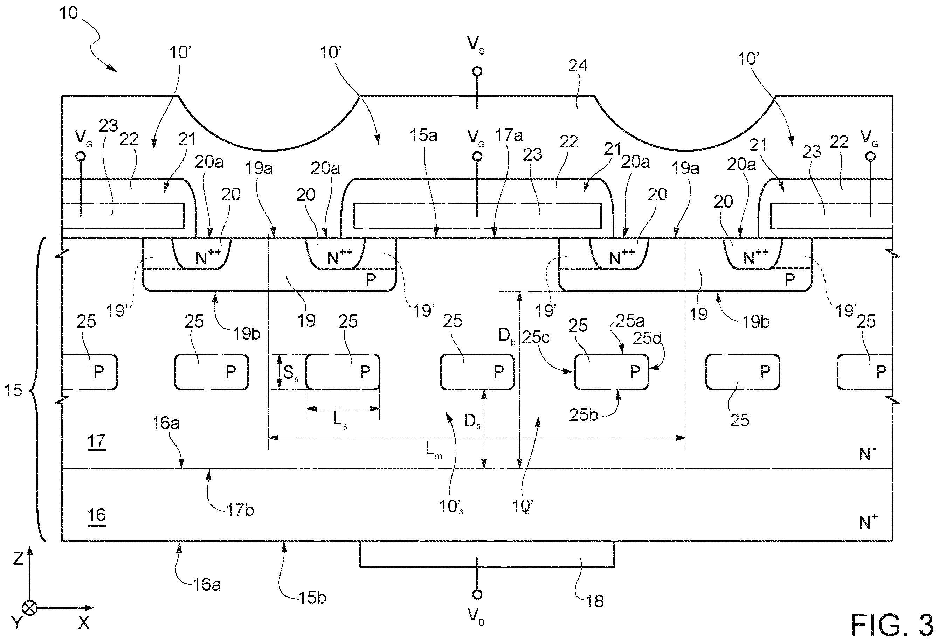

These embodiments may also be combined with each other. For example, according to a further embodiment of the device 10 (for example shown in Figure 3 and wherein three doped pocket regions 25 are present for each MOSFET 10'), the gate structures 21 are at least partially vertically aligned (i.e., overlap) with some of the doped pocket regions 25 which in turn are vertically staggered with respect to the source regions 20 and the source regions 20 are at least partially vertically aligned with other doped pocket regions 25.

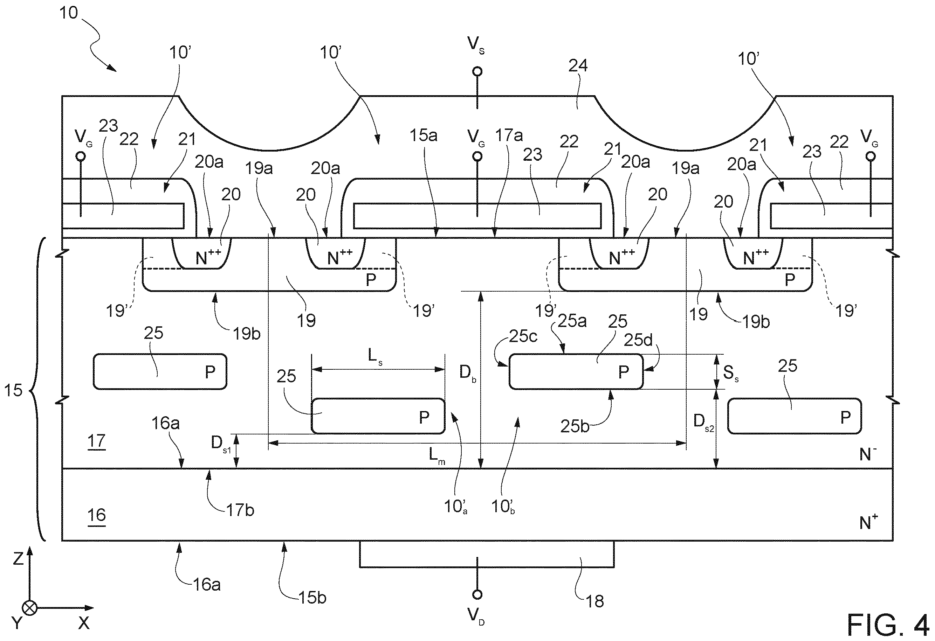

As an alternative to what has been previously described and as shown for example in Figure 4, the doped pocket regions 25 may be arranged laterally to each other along the axis X but at different levels from each other along the axis Z. In other words, the doped pocket regions 25 may be arranged in succession to each other along the axis X but at different heights from each other with respect to the substrate 16. In this case there will be different minimum distances Dₛ (in the example of Figure 4, a first and a second minimum distance Dₛ₁ and Dₛ₂) and each of them meets the condition previously described on the ratio Dₛ/D_{b}.

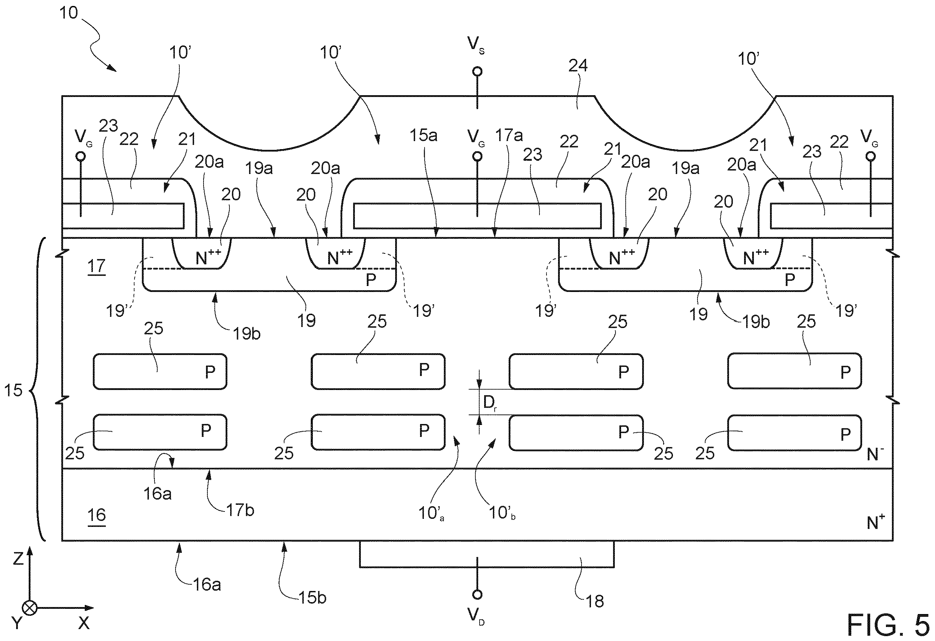

Furthermore, it is also possible to have multiple doped pocket regions 25 which are superimposed on each other and mutually spaced in the direction parallel to the axis Z, as shown in Figure 5. In other words, the doped pocket regions 25 may also be at least partially vertically aligned (i.e., they may overlap or underlie) with each other. For example, it is possible to have groups of doped pocket regions 25, lateral to each other along the axis X and wherein each group comprises two or more respective doped pocket regions 25 which are superimposed on each other parallel to the axis Z. For example, the doped pocket regions 25 superimposed on each other parallel to the axis Z have, parallel to the axis Z, respective mutual distances Dᵣ which may be, for example, greater than about 0.5 µm. This embodiment is combinable with any of the embodiments described herein.

In a known manner, during use the device 10 is biased by applying a source voltage Vₛ to the source metallization 24 and therefore to the source regions 20 (for example a ground reference voltage GND, i.e. at 0 V), while a drain voltage V_{D} (e.g., comprised between 30 V and 1700 V) is applied to the drain metallization 18 and therefore to the substrate 16. In other words, a drain-source voltage V_{DS} is applied between the source terminal and the drain terminal of the MOSFETs 10'.

Furthermore, when the gate regions 23 are biased to a gate voltage V_{G} greater than a gate threshold voltage V_{G,th} and such as to generate respective flows of charge carriers (here electrons) through the channel regions 19' of the MOSFETs 10', the device 10 is in conduction state. Conversely, when the gate voltage V_{G} applied to the gate regions 23 is lower than the gate threshold voltage V_{G,th} and such as to inhibit the generation of charge carrier flows through the channel regions 19' of the MOSFETs 10', the device 10 is in inhibition state.

The overall conduction of the device 10 is therefore a function of all the MOSFETs 10' and, in particular, of both electron flows of each MOSFET 10' (each corresponding to a respective MOSFET portion 10'ₐ, 10'_{b}) . Consequently, when suitably biased, the device 10 generates a drain-source current I_{DS} between the source terminal and the drain terminal of the MOSFETs 10'.

It has been verified that the doped pocket regions 25 reduce the ringing phenomenon of the device 10 with respect to the known case wherein the doped pocket regions 25 are absent, for example also reducing by 70-80% the amplitude of the overshoots of the drain-source voltage V_{DS} and the drain-source current I_{DS} during the switching of the MOSFETs 10'. It has been verified that this beneficial effect is not due to the establishment of the PTO in the MOSFETs 10' and is independent of this phenomenon.

In fact, the doped pocket regions 25 increase the dynamic capacitive coupling of the source terminal with the drain terminal, thus allowing the decrease of the oscillations of the drain-source voltage V_{DS} during the switching of the MOSFETs 10'.

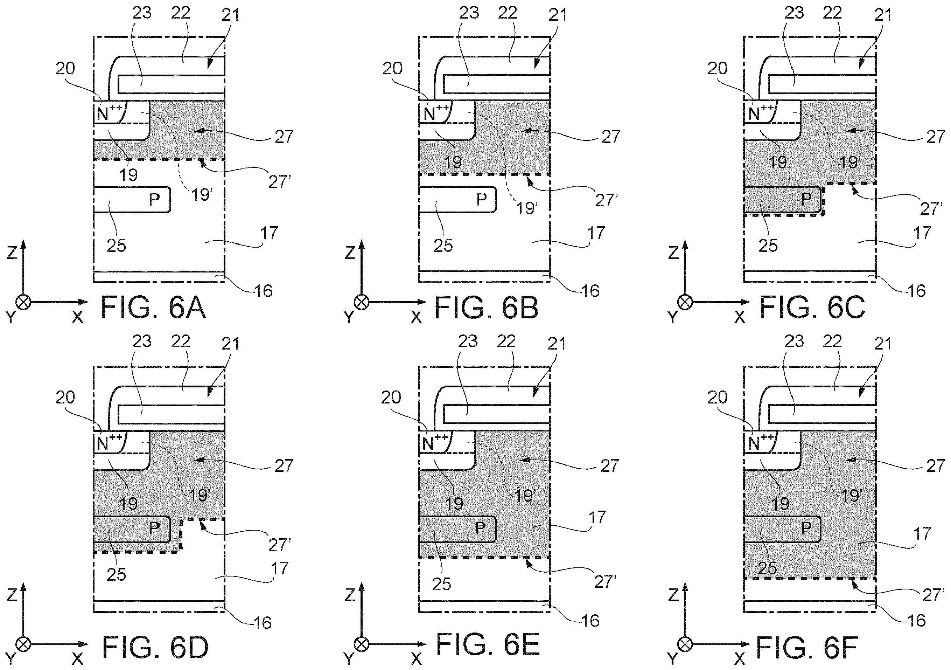

In particular, Figures 6A-6F show the behavior, during the dynamic phase, of a depletion region 27 of one of the MOSFETs 10' as the drain-source voltage V_{DS} increases. By way of example, Figures 6A-6F show only the first MOSFET portion 10'ₐ of one of the MOSFETs 10', although similar considerations also apply to the second MOSFET portion 10'_{b} and to all the MOSFETs 10'.

As may be seen in Figures 6A-6F, as the drain-source voltage V_{DS} increases (where Figure 6A corresponds to the case of minimum value of the drain-source voltage V_{DS} and Figure 6F corresponds to the case of maximum value of the drain-source voltage V_{DS}) the depletion region 27 also expands which, starting from the source region 20, progresses towards the substrate 16. In other words, the depletion region 27 has a lower delimiting surface 27' (corresponding to the lower limit along the axis Z of the depletion region 27 and therefore at the lower limit of the region of the drift layer 17 wherein the minority charge carriers, here holes, are greater than the majority charge carriers, here electrons) which extends towards the substrate 16 the more, the more the drain-source voltage V_{DS} increases.

In Figures 6A and 6B, the lower delimiting surface 27' of the depletion region 27 has not yet reached the underlying doped pocket region 25, which therefore has no role in the distribution of the electric field and in the distribution of the holes in the MOSFET 10' considered. In other words, the lower delimiting surface 27' of the depletion region 27 extends above the doped pocket region 25.

In Figure 6C, the depletion region 27 has just reached and touched the doped pocket region 25. In this case, the lower delimiting surface 27' of the depletion region 27 moves immediately below the doped pocket region 25, along the axis Z. In other words, the depletion region 27 extends both through the part of the drift layer 17 placed above the doped pocket region 25 and through the doped pocket region 25. In this case, it has been verified that a hole flow is established between the source region 20 and the doped pocket region 25, with a substantially vertical direction.

In Figures 6D-6F, the depletion region 27 expands more and more below the doped pocket region 25 and towards the substrate 16. In other words, the lower delimiting surface 27' of the depletion region 27, which is interposed along the axis Z between the doped pocket region 25 and the substrate 16, detaches from the doped pocket region 25 and moves more and more towards the substrate 16. Simultaneously, the hole flow between the source region 20 and the doped pocket region 25 intensifies, increasing the electrical coupling between the source region 20 and the doped pocket region 25.

It has been verified that, when the depletion region 27 gets to extend through the doped pocket region 25, the drain-source voltage V_{DS} and the drain-source current I_{DS} reduce their rate of change over time, with the same other electrical and physical parameters of the MOSFET 10'. This causes the drain-source voltage V_{DS} and the drain-source current I_{DS} to oscillate over time with smaller maximum amplitudes with respect to the case in which the doped pocket region 25 is absent, thus reducing the ringing effect.

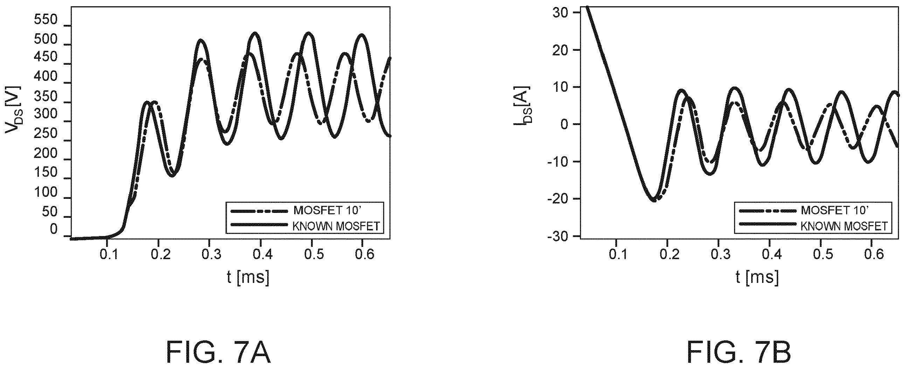

Figures 7A and 7B show, for one of the MOSFETs 10', the trends over time respectively of the drain-source voltage V_{DS} and of the drain-source current I_{DS} when the MOSFET 10' switches from the ON-state to the OFF-state (indicatively at about t=t*=0.1ps or less). In particular, this is shown both for one of the MOSFETs 10' and for a known MOSFET wherein the doped pocket regions 25 are absent, to compare their respective electrical properties.

After switching at t=t*=0.1ps, a transient time interval is present wherein the drain-source voltage V_{DS} and the drain-source current I_{DS} oscillate in a damped manner around respective average values before converging towards the latter (in the example of Figures 7A and 7B, respectively about 400V and about 0A).

During this transient time interval, the amplitude of the oscillations of the drain-source voltage V_{DS} and the drain-source current I_{DS} is smaller in the case in which the doped pocket regions 25 are present with respect to the known case in which they are absent.

Furthermore, it has been verified that the presence of the doped pocket regions 25 does not significantly alter the other electrical and operating properties of the device 10 (e.g., a breakdown voltage, a drain-source on-resistance, a body diode current of the MOSFETs 10').

The effectiveness of ringing reduction is generally maximum when the minimum distance Dₛ of the doped pocket regions 25 from the substrate 16 is zero (i.e. Dₛ=0pm) and therefore when the doped pocket regions 25 are in contact with the upper surface 16a of the substrate 16.

Furthermore, in general the vertical position of the doped pocket regions 25 in the drift layer 17 depends on a rate of change of the recovery current di/dt of the MOSFETs 10' at which they are designed and electrically controlled to operate. In detail, the recovery current is the reverse drain-source current flowing in the MOSFET 10' in the transient time interval, during a rising phase of the drain-source voltage wherein the drain-source current changes sign after a direct current flow. The rate of change of the recovery current di/dt is also indicative of the static or dynamic regime of the MOSFET 10' (e.g., static regime for di/dt<1A/ns and dynamic regime for values greater than di/dt) .

In other words, the range of change of the first ratio D_{s/}D_{b} between the minimum distance Dₛ and the minimum distance D_{b} (in particular, its upper limit) depends on the rate of change of the recovery current di/dt of the MOSFETs 10' . This is due to the fact that, when the rate of change of the recovery current di/dt increases, the doped pocket regions 25 are to be closer to the substrate 16 to continue to ensure dynamic capacitive coupling between the source regions 20 and the substrate 16 sufficient to have a high damping of the ringing.

According to one embodiment, if the MOSFETs 10' are configured to work at 0A/ns<di/dt≤1A/ns the first ratio Dₛ/D_{b} is comprised between 0% and about 70% (in particular between about 50% and about 70%).

According to one embodiment, if the MOSFETs 10' are configured to work at 1A/ns<di/dt≤2A/ns the first ratio Dₛ/D_{b} is comprised between 0% and about 60% (in particular between about 40% and about 60%).

According to one embodiment, if the MOSFETs 10' are configured to work at 2A/ns<di/dt≤3A/ns the first ratio Dₛ/D_{b} is comprised between 0% and about 50% (in particular between about 30% and about 50%).

According to one embodiment, if the MOSFETs 10' are configured to work at 3A/ns<di/dt≤4A/ns the first ratio Dₛ/D_{b} is comprised between 0% and about 40% (in particular between about 20% and about 40%).

According to one embodiment, if the MOSFETs 10' are configured to work at 4A/ns<di/dt≤5A/ns the first ratio Dₛ/D_{b} is comprised between 0% and about 30% (in particular between about 10% and about 30%).

According to one embodiment, if the MOSFETs 10' are configured to work at 5A/ns<di/dt≤6A/ns the first ratio Dₛ/D_{b} is comprised between 0% and about 200.

According to one embodiment, if the MOSFETs 10' are configured to work at 6A/ns<di/dt≤7A/ns the first ratio Dₛ/D_{b} is comprised between 0% and about 10%.

According to one embodiment, if the MOSFETs 10' are configured to work at di/dt>7A/ns the first ratio Dₛ/D_{b} is equal to about 0%.

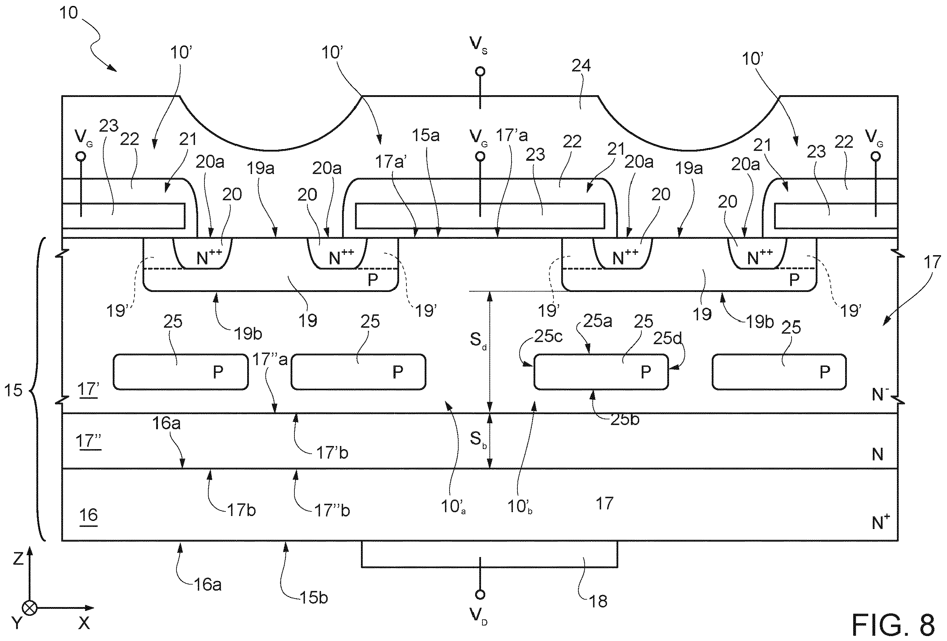

Figure 8 shows a further embodiment of the device 10. In particular, the device 10 of Figure 8 is a high-power device, i.e. it is designed and configured to work at drain-source voltages V_{DS} for example higher than about 1200 V.

In the example of Figure 8, the device 10 is similar to the embodiment of Figure 1 wherein two doped pocket regions 25 are present for each MOSFET 10', lateral to each other along the axis X and at the same level along the axis Z. Nonetheless, the device 10 may be similarly based on any of the embodiments previously described and therefore the following considerations apply in a similar manner also to the other embodiments.

In particular, unlike in Figure 1 wherein the whole drift layer 17 has the second dopant concentration, in Figure 8 the drift layer 17 comprises a main drift region 17', with the first electrical conductivity type (here N-type) and the second dopant concentration, and a drift buffer region 17", with the first electrical conductivity type (here N-type) and a buffer dopant concentration greater than the second dopant concentration. In other words, in Figure 1 the drift layer 17 is formed by the sole drift main region 17', while in Figure 8 the drift layer 17 is formed by the drift main region 17' and by the drift buffer region 17".

In particular, the buffer dopant concentration of the drift buffer region 17" is comprised between about 25% more than the second dopant concentration (i.e. between the sum of the second dopant concentration and about 250 of the second dopant concentration) and about 3·10¹⁶ at/cm³, and for example it is equal to about 1.3·10¹⁶ at/cm³. As a result, the buffer dopant concentration is greater of at least about 25% more than the second dopant concentration.

The drift buffer region 17" extends over the substrate 16 and the drift main region 17' extends over the drift buffer region 17". Consequently, the drift buffer region 17" is interposed along the axis Z between the substrate 16 and the drift main region 17'.

In greater detail, the drift buffer region 17" has an upper surface 17"a and a lower surface 17"b (which is in contact with the upper surface 16a of the substrate 16 and defines the lower surface 17b of the drift layer 17) opposite to each other along the axis Z, and the drift main region 17' has an upper surface 17'a (which defines the upper surface 17a of the drift layer 17) and a lower surface 17'b (in contact with the upper surface 17"a of the drift buffer region 17") opposite to each other along the axis Z.

The drift buffer region 17" has a maximum thickness S_{b} along the axis Z and the drift main region 17' has a minimum thickness S_{d} along the axis Z which is greater than, or equal to, the maximum thickness S_{b} of the drift buffer region 17". In particular, the drift buffer region 17" and the drift main region 17' have the thicknesses S_{b} and S_{d} which are substantially constant parallel to the axis Z. For example, the maximum thickness S_{b} of the drift buffer region 17" is measured along the axis Z between the upper surface 17"a and the lower surface 17"b of the drift buffer region 17", and the minimum thickness S_{d} of the drift main region 17' is measured along the axis Z between the body regions 19 (in detail, the lower surface 19b of one of the body regions 19) and the lower surface 17'b of the drift main region 17'.

According to one embodiment, a ratio (or fourth ratio) S_{b}/D_{b} between the maximum thickness S_{b} of the drift buffer region 17" and the minimum distance D_{b} of the body regions 19 from the substrate 16 is comprised (boundary values included) between about 30% and about 50% and is, for example, equal to about 40%.

The doped pocket regions 25 may extend entirely into the drift buffer region 17", or entirely into the drift main region 17', or in part into the drift buffer region 17" and in part into the drift main region 17'.

In particular, it has been verified that the presence of the drift buffer region 17" with higher doping than the drift main region 17' prevents the snappy behavior of the MOSFETs 10'.

In fact, the drift buffer region 17" increases the recombination rate of minority charge carriers (here holes) owing to its higher doping. In other words, the average lifetime of the holes in the drift layer 17 is reduced and therefore, even when the device 10 operates at high temperatures (e.g., higher than about 170°C), the holes are caused to recombine before reaching the substrate 16, thus preventing them from suddenly recombining upon contacting the upper surface 16a of the substrate 16. In particular, the drift buffer region 17" prevents, in static regime, the lower delimiting surface 27' of the depletion region 27 from reaching the upper surface 16a of the substrate 16. This therefore avoids the snappy behavior of the MOSFETs 10'.

Furthermore, it has been verified that the presence of the drift buffer region 17" in the drift layer 17 does not significantly alter the operation and the other electrical parameters of the device 10 (e.g., the on-resistance and the breakdown voltage of the MOSFETs 10'). In particular, the values of the buffer dopant concentration and the maximum thickness S_{b} of the drift buffer region 17" are chosen within the ranges previously described in such a way as to keep the on-resistance of the MOSFETs 10' substantially unchanged.

From an examination of the characteristics of the invention made according to the present invention the advantages that it affords are evident.

The presence of the doped pocket regions 25 allows the ringing phenomenon in the MOSFETs 10' of the device 10 to be effectively reduced during the "recovery" phase of the MOSFETs 10', without however negatively altering the other electrical and physical properties of the device 10. This is particularly significant in the present MOSFETs 10' that have a reduced distance between the two body regions 19 (e.g., measured parallel to the axis X, for example between lateral surfaces of the body regions 19 that are faced to each other across the interposed part of the drift layer 17), e.g. lower than 1 um.

Furthermore, this advantage is achieved without reducing the switching speed of the MOSFETs 10', without increasing the area of the device 10 and without adding complicated electronic circuits external to the device 10.

Furthermore, the doped pocket regions 25 may be formed in the drift layer 17 through implant or "channeling" of the doping species. This allows the device 10 to be manufactured in a simple manner and, especially with reference to the channeling technique, ensures an accurate control of the size of the doped pocket regions 25 and therefore of the electrical properties of the device 10.

Furthermore, using the drift layer 17 comprising the drift buffer region 17" and the drift main region 17' prevents the MOSFETs 10' of the device 10 from having snappy behavior and therefore improves the electrical properties, the operation and the reliability of the device 10.

Finally, it is clear that modifications and variations may be made to the invention described and illustrated herein without thereby departing from the scope of the present invention, as defined in the attached claims. For example, the different embodiments described may be combined with each other to provide further solutions.

The shape, number and arrangement of the doped pocket regions 25 may vary, as previously described and within the ranges previously discussed.

Furthermore, what has been previously described also applies to the case in which the device 10 comprises a single MOSFET 10' with a single portion 10'ₐ or 10'_{b} (e.g., with only the first MOSFET portion 10'ₐ).

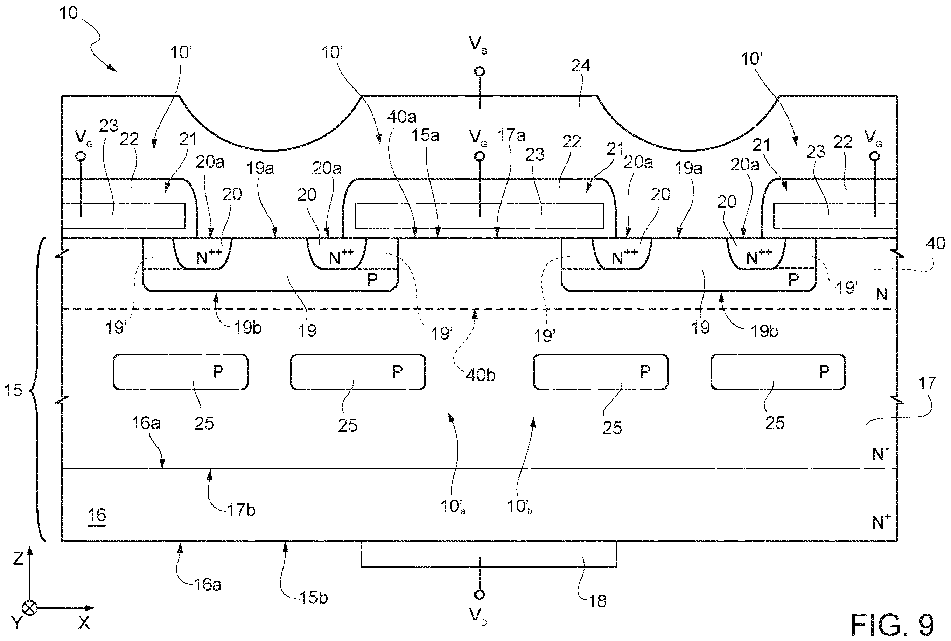

Furthermore and in a manner known per se, the drift layer 17 of the device 10 may include a current spreading layer (CSL) 40, as shown in Figure 9.

In detail, Figure 9 shows an embodiment of the device 10 similar to that of Figure 1, by way of example. Nonetheless, the CSL 40 may similarly be present in each of the embodiments described herein.

The CSL 40 extends into the drift layer 17 (in particular, into the drift main region 17') starting from the upper surface 15a of the semiconductor body 15 and towards the substrate 16, without reaching the latter, in such a way that the body regions 19 are accommodated (e.g., entirely accommodated) in the CSL 40. In particular, the CSL 40 is at a distance along the axis Z from the substrate 16 and from the drift buffer region 17", when the latter is present.

For example, along the axis Z and below the body regions 19, the CSL 40 has a thickness equal to about 0.1 µm or 0.2 µm. In other words, the CSL 40 has an upper surface 40a (which forms the upper surface 17a of the drift layer 17) and a lower surface 40b, opposite to each other along the axis Z; the lower surface 40b of the CSL 40 extends below the body regions 19 along the axis Z and is distant, along the axis Z, by about these 0.1µm-0.2µm from the lower surfaces 19b of the latter.

The CSL 40 has the first electrical conductivity type (here of N-type) and has a higher CSL dopant concentration than the second dopant concentration (e.g., of the order of magnitude of about 1·10¹⁷ at/cm³).

As known, the CSL 40 increases and homogenizes the diffusion of the charge flows flowing below the gate structures 21 in the drift layer 17.

Furthermore, as shown in Figures 10A and 10B, the shape of the doped pocket regions 25 in the plane XY may vary.

In particular, Figures 10A and 10B show top views (i.e. parallel to the plane XY) of the device 10. For ease of view, Figures 10A and 10B show only the upper surface 15a of the semiconductor body 15 and, in dotted lines, the doped pocket regions 25 buried in the semiconductor body 15; in other words, the other elements of the device 10 previously described (e.g., the body regions 19, the source regions 20, the gate structures 21, etc.) are not shown here not to obscure the understanding of the Figure, although they are obviously present.

In detail, Figure 10A shows the embodiment of the device 10, previously described, wherein the doped pocket regions 25 have the shape of a strip with main extension parallel to the axis Y and with a length along the axis Y which is substantially equal to the length of the body regions 19 along the axis Y. For example, in this Figure the doped pocket regions 25 have a rectangular shape.

Nonetheless, and as shown for example in Figure 10B, the shape of the doped pocket regions 25 parallel to the axis Y may be different.

For example, the doped pocket regions 25 may be discontinuous parallel to the axis Y.

In particular, Figure 10B shows the case in which the doped pocket regions 25 are arranged in a matrix or checkerboard pattern parallel to the plane XY. In the matrix, the doped pocket regions 25 may be aligned in columns parallel to the axis Y (as shown in Figure 10A), or they may be misaligned with each other parallel to the axis Y (e.g., the doped pocket regions 25 of a certain row may be laterally staggered with respect to the doped pocket regions 25 of the two first neighboring rows which are adjacent, in the matrix, to the row considered and may be aligned parallel to the axis Y with the doped pocket regions 25 of the two rows adjacent, in the matrix, to these two first neighboring rows).

Parallel to the plane XY, these doped pocket regions 25 may have a rectangular shape (as shown in Figure 10B), a square shape, a circular shape, a hexagonal shape, etc.

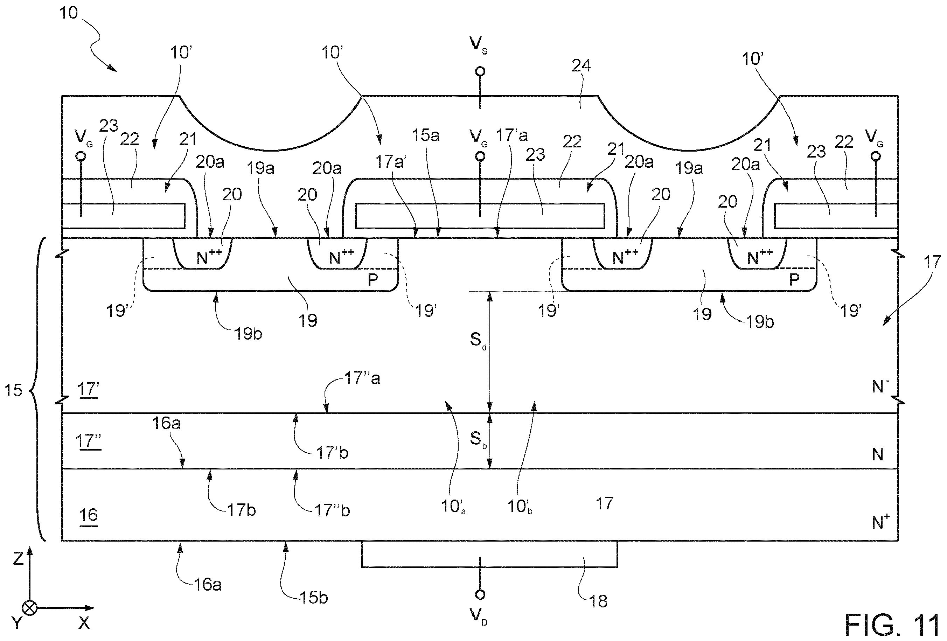

Furthermore, as shown in Figure 11, the device 10 may have the drift layer 17 comprising the drift buffer region 17" and the drift main region 17' and may instead not have the doped pocket regions 25. In this embodiment in which the doped pocket regions 25 are absent, the device 10 does not have snappy behavior and therefore may operate in an optimized manner at high powers.

## Claims

1. An electronic device (10) comprising a semiconductor body (15) of silicon carbide, SiC, having an upper surface (15a) and a lower surface (15b) opposite to each other along a first axis (Z) and comprising:
- a drain substrate (16) extending into the semiconductor body (15) starting from the lower surface (15b) of the semiconductor body (15) and having a first electrical conductivity type and a first dopant concentration;
- a drift layer (17) extending into the semiconductor body (15) starting from the upper surface (15a) of the semiconductor body (15) and up to the drain substrate (16) and having the first electrical conductivity type and a second dopant concentration lower than the first dopant concentration;
- at least one first body region (19) which extends into the semiconductor body (15) starting from the upper surface (15a) of the semiconductor body (15) and at a distance from the drain substrate (16), is accommodated in the drift layer (17) and has a second electrical conductivity type opposite to the first electrical conductivity type; and
- at least one first source region (20) which extends into the semiconductor body (15) starting from the upper surface (15a) of the semiconductor body (15), is accommodated in the first body region (19) so as to be spaced from the drift layer (17) and has the first electrical conductivity type,
the electronic device (10) further comprising at least one first gate structure (21) extending on the upper surface (15a) of the semiconductor body (15) and superimposed along the first axis (Z) on the first body region (19) in such a way as to form, with the first source region (20), the first body region (19), the drift layer (17) and the drain substrate (16), a first MOSFET portion (10'ₐ) of a first MOSFET (10'),
wherein the semiconductor body (15) further comprises at least one first doped pocket region (25) which is buried in the drift layer (17), has the second electrical conductivity type and is at least partially aligned along the first axis (Z) with the first source region (20) and/or with the first gate structure (21).

2. The electronic device (10) according to claim 1, wherein the first doped pocket region (25) has a minimum doped pocket distance (Dₛ) from the drain substrate (16) along the first axis (Z) and the first body region (19) has a minimum body distance (D_{b}) from the drain substrate (16) along the first axis (Z), and
wherein a first ratio (Dₛ/D_{b}) between the minimum doped pocket distance (Dₛ) and the minimum body distance (D_{b}) is comprised between 0% and 700 or is equal to 0% or 700.

3. The electronic device (10) according to claim 2, wherein:
if the first MOSFET (10') is configured to work at a rate of change of the recovery current (di/dt) comprised between 0 A/ns and 1 A/ns or equal to 1 A/ns, the first ratio (Dₛ/D_{b}) is comprised between 0% and 700 or is equal to 0% or 70%;
if the first MOSFET (10') is configured to work at the rate of change of the recovery current (di/dt) comprised between 1 A/ns and 2 A/ns or equal to 2 A/ns, the first ratio (Dₛ/D_{b}) is comprised between 0% and 600 or is equal to 0% or 60%;
if the first MOSFET (10') is configured to work at the rate of change of the recovery current (di/dt) comprised between 2 A/ns and 3 A/ns or equal to 3 A/ns, the first ratio (Dₛ/D_{b}) is comprised between 0% and 50% or is equal to 0% or 50%;
if the first MOSFET (10') is configured to work at the rate of change of the recovery current (di/dt) comprised between 3 A/ns and 4 A/ns or equal to 4 A/ns, the first ratio (Dₛ/D_{b}) is comprised between 0% and 40% or is equal to 0% or 40%;
if the first MOSFET (10') is configured to work at the rate of change of the recovery current (di/dt) comprised between 4 A/ns and 5 A/ns or equal to 5 A/ns, the first ratio (Dₛ/D_{b}) is comprised between 0% and 30% or is equal to 0% or 30%;
if the first MOSFET (10') is configured to work at the rate of change of the recovery current (di/dt) comprised between 5 A/ns and 6 A/ns or equal to 6 A/ns, the first ratio (Dₛ/D_{b}) is comprised between 0% and 200 or is equal to 0% or 20%;
if the first MOSFET (10') is configured to work at the rate of change of the recovery current (di/dt) comprised between 6 A/ns and 7 A/ns or equal to 7 A/ns, the first ratio (Dₛ/D_{b}) is comprised between 0% and 10% or is equal to 0% or 10%;
if the first MOSFET (10') is configured to work at the rate of change of the recovery current (di/dt) greater than or equal to 7 A/ns, the first doped pocket region (25) is in contact with the drain substrate (16).

4. The electronic device (10) according to any of the preceding claims, wherein the first doped pocket region (25) has, along a second axis (X) orthogonal to the first axis (Z), a maximum doped pocket width (Lₛ) and the first MOSFET (10') has, along the second axis (X), an average MOSFET width (Lₘ),
wherein a second ratio (Lₛ/Lₘ) between the maximum doped pocket width (Lₛ) and the average MOSFET width (Lₘ) is comprised between 15% and 30% or is equal to 150 or 300.

5. The electronic device (10) according to any of the preceding claims when dependent on claim 2, wherein the first doped pocket region (25) has a maximum doped pocket thickness (Sₛ) along the first axis (Z), and
wherein a third ratio (Sₛ/D_{b}) between the maximum doped pocket thickness (Sₛ) and the minimum body distance (D_{b}) is comprised between 10% and 30% or is equal to 10% or 300.

6. The electronic device (10) according to any of the preceding claims, wherein the first doped pocket region (25) has a doped pocket dopant concentration which is higher than the second dopant concentration of the drift layer (17) and, in particular, is comprised between 1·10¹⁷ at/cm³ and 5·10¹⁷ at/cm³ or is equal to 1·10¹⁷ at/cm³ or 5·10¹⁷ at/cm³.

7. The electronic device (10) according to any of the preceding claims, wherein the first doped pocket region (25) is, along the first axis (Z):
aligned with the first source region (20) and staggered with respect to the first gate structure (21); or
aligned with the first gate structure (21) and staggered with respect to the first source region (20); or
partially aligned with the first source region (20) and partially aligned with the first gate structure (21).

8. The electronic device (10) according to any of the preceding claims, wherein the semiconductor body (15) further comprises:
- at least one second body region (19) which extends into the semiconductor body (15) starting from the upper surface (15a) of the semiconductor body (15) and at a distance from the drain substrate (16), is lateral to the first body region (19) orthogonally to the first axis (Z), is at a distance from the first body region (19) orthogonally to the first axis (Z), is accommodated in the drift layer (17), and has the second electrical conductivity type; and
- at least one second source region (20) which extends into the semiconductor body (15) starting from the upper surface (15a) of the semiconductor body (15), is accommodated in the second body region (19) so as to be spaced from the drift layer (17) and has the first electrical conductivity type,
wherein the first gate structure (21) is also superimposed parallel to the first axis (Z) on the second body region (19) in such a way as to form, with the second source region (20), the second body region (19), the drift layer (17) and the drain substrate (16), a second MOSFET portion (10'_{b}) of the first MOSFET (10'),
wherein the semiconductor body (15) further comprises at least one second doped pocket region (25) that is buried in the drift layer (17), has the second electrical conductivity type and is at least partially aligned, parallel to the first axis (Z), with the second source region (20) and/or with the first gate structure (21).

9. The electronic device (10) according to claim 8, wherein the first doped pocket region (25) and the second doped pocket region (25) are at least partially aligned with each other orthogonally to the first axis (Z) or are staggered with respect to each other orthogonally to the first axis (Z).

10. The electronic device (10) according to claim 8 or 9, wherein the semiconductor body (15) further comprises at least one third source region (20) which extends into the semiconductor body (15) starting from the upper surface (15a) of the semiconductor body (15), is accommodated in the second body region (19) so as to be lateral to the second source region (20) and to be spaced from the drift layer (17) and the second source region (20) and has the first electrical conductivity type,
the electronic device (10) further comprising at least one second gate structure (21) which extends over the upper surface (15a) of the semiconductor body (15), is lateral to the first gate structure (21) and is superimposed parallel to the first axis (Z) on the second body region (19) in such a way as to form, with the third source region (20), the second body region (19), the drift layer (17) and the drain substrate (16), a respective first MOSFET portion (10'ₐ) of a second MOSFET (10'),
wherein the semiconductor body (15) further comprises at least one third doped pocket region (25) which is buried in the drift layer (17), has the second electrical conductivity type and is at least partially aligned, parallel to the first axis (Z), with the third source region (20) and/or with the second gate structure (21).

11. The electronic device (10) according to any of the preceding claims, wherein the semiconductor body (15) further comprises at least one further doped pocket region (25) which is buried in the drift layer (17), has the second electrical conductivity type and is at least partially aligned, along the first axis (Z), with the first doped pocket region (25).

12. The electronic device (10) according to any of the preceding claims, wherein the drift layer (17) comprises a drift main region (17') and a drift buffer region (17"), the drift buffer region (17") being interposed along the first axis (Z) between the drift main region (17') and the drain substrate (16),
wherein the drift main region (17') has the first electrical conductivity type and said second dopant concentration and the drift buffer region (17") has the first electrical conductivity type and a buffer dopant concentration higher than the second dopant concentration.

13. The electronic device (10) according to claim 12, wherein the buffer dopant concentration of the drift buffer region (17") is comprised between 25% more than the second dopant concentration and 3·10¹⁶ at/cm³ or is equal to 250 more than the second dopant concentration or 3·10¹⁶ at/cm³.

14. The electronic device (10) according to claim 2 and one of claims 12 and 13, wherein the drift buffer region (17") has a maximum thickness (S_{b}) along the first axis (Z), and
wherein a fourth ratio (S_{b}/D_{b}) between the maximum thickness (S_{b}) and the minimum body distance (D_{b}) is comprised between 30% and 50% or is equal to 30% or 500.

15. An apparatus comprising an electronic device (10) according to any of claims 1-14.
